# EUROPEAN PATENT APPLICATION

(11) **EP 4 195 304 A1**
(43) Date of publication of application: **14.06.2023**
(21) Application number: 21853832.0
(22) Date of filing: 02.08.2021
(51) Int. Cl.: H01L 51/50

(54) **ORGANIC ELECTROLUMINESCENCE ELEMENT**

(30) Priority: 05.08.2020 JP 2020132952
(71) Applicant: Hodogaya Chemical Co., Ltd., Tokyo, 105-0021 (JP); SFC Co., Ltd., Cheongju-si, Chungcheongbuk-do 28122 (KR)
(72) Inventor: HIRAYAMA, Yuta, Tokyo 104-0028 (JP); YAMAMOTO, Takeshi, Tokyo 104-0028 (JP); KASE, Kouki, Tokyo 104-0028 (JP); HAYASHI, Shuichi, Tokyo 104-0028 (JP); CHA Soon-Wook, Cheongju-si, Chungcheongbuk-do 28122 (KR); JOO Sung-Hoon, Cheongju-si, Chungcheongbuk-do 28122 (KR); YANG Byung-Sun, Cheongju-si, Chungcheongbuk-do 28122 (KR); KIM Ji-Hwan, Cheongju-si, Chungcheongbuk-do 28122 (KR)
(74) Representative: Forstmeyer, Dietmar
(86) International application number: PCT/JP2021/028589
(87) International publication number: WO 2022/030438

(57) **Abstract**

An objective of the present invention is to provide an organic EL device having high efficiency, low driving voltage and long lifetime by using a material for organic EL devices offering excellent hole injectability and transportability, electron blockability, stability in a thin-film state, and durability, and also by employing, in combination, the aforementioned material and various other materials for organic EL devices offering excellent hole/electron injectability and transportability, electron blockability, stability in a thin-film state, and durability, in a manner that the properties of each material can be brought out effectively. The present invention relates to an organic electroluminescence device having, between an anode and a cathode, at least a hole transport layer, a light-emitting layer, and an electron transport layer in this order from the anode side, wherein the hole transport layer contains a triarylamine compound having a specific structure.

## Description

### Technical Field

The present invention relates to an organic electroluminescence device which is a self-luminous light-emitting device suitable for various display devices, and more specifically, to an organic electroluminescence device (abbreviated hereinbelow as "organic EL device") employing a specific arylamine compound.

### Background Art

Organic EL devices, which are self-luminous light-emitting devices, are brighter, have better visibility, and are capable of clearer display compared to liquid crystal devices. Therefore, organic EL devices have been actively researched.

In 1987, C. W. Tang et al. of Eastman Kodak Company developed a device having a multilayer structure wherein various roles for light emission were allotted respectively to different materials, thereby achieving practical utilization of organic EL devices using organic materials. They developed a laminate including a layer of a fluorescent substance capable of transporting electrons and a layer of an organic substance capable of transporting holes. Injecting both charges into the fluorescent substance layer causes emission of light, achieving a high luminance of 1,000 cd/m² or higher at a voltage of 10 V or less (see, for example, Patent Literatures 1 and 2).

Many improvements have been heretofore made for practical utilization of organic EL devices. Further subdivision of the roles of various layers within the multilayer structure has yielded an electroluminescent device wherein an anode, a hole injection layer, a hole transport layer, a light-emitting layer, an electron transport layer, an electron injection layer, and a cathode are formed sequentially on a substrate, achieving high efficiency and high durability (see, for example, Non-Patent Literature 1).

To further improve luminous efficiency, attempts have been made to employ triplet excitons. Also, the use of phosphorescent compounds has been investigated (see, for example, Non-Patent Literature 2).

Further, devices employing light emission by thermally activated delayed fluorescence (TADF) have been developed. In 2011, Adachi et al. of Kyushu University achieved an external quantum efficiency of 5.3% with a device using a thermally activated delayed fluorescence material (see, for example, Non-Patent Literature 3).

A light-emitting layer can be prepared by doping a charge-transporting compound, typically called a "host material", with a fluorescent compound, a phosphorescent compound, or a material emitting delayed fluorescence. As described in the aforementioned Non-Patent Literatures, the selection of organic materials in an organic EL device greatly affects various properties such as efficiency and durability of that device (see, for example, Non-Patent Literature 2).

In organic EL devices, charges injected from the respective electrodes recombine in the light-emitting layer to emit light. Thus, what is important is to efficiently deliver the charges, i.e., the holes and electrons, to the light-emitting layer, which requires the device to have excellent carrier balance. By enhancing hole injectability and also enhancing electron blockability for blocking the electrons injected from the cathode, it is possible to increase the probability of hole-electron recombination. Also, by confining excitons generated within the light-emitting layer, high luminous efficiency can be achieved. Therefore, the hole-transporting material serves an important role, and there is thus a demand for a hole-transporting material having high hole injectability, high hole mobility, high electron blockability, and high durability against electrons.

In terms of device longevity, the material's heat resistance and amorphous properties are also important. With a material having poor heat resistance, thermal decomposition and material degradation occur, even at low temperatures, due to heat produced when the device is driven. With a material having poor amorphous properties, a thin film undergoes crystallization in a short time, resulting in device degradation. Hence, the material to be used requires high heat resistance and good amorphous properties.

Examples of known hole-transporting materials used heretofore in organic EL devices include N,N'-diphenyl-N,N'-di(α-naphthyl)-benzidine ("NPD") and various aromatic amine derivatives (see, for example, Patent Literatures 1 and 2). NPD does have good hole transportability, but its glass transition point (Tg), serving as an index of heat resistance, is as low as 96°. This may cause degradation in device properties due to crystallization in high-temperature conditions (see, for example, Non-Patent Literature 4). Further, among the aromatic amine derivatives disclosed in the aforementioned Patent Literatures, there are compounds having excellent mobility, such as hole mobility of 10⁻³ cm²/Vs or greater (see, for example, Patent Literatures 1 and 2). These compounds, however, have insufficient electron blockability, thus allowing a portion of the electrons to pass through the light-emitting layer and thereby making it impossible to expect improvements in luminous efficiency. To achieve even higher efficiency, there is a demand for a material having higher electron blockability and higher heat resistance and providing a more stable thin film. Further, aromatic amine derivatives having high durability have been reported (see, for example, Patent Literature 3), but these compounds are used as charge-transporting materials to be used in electrophotographic photoreceptors, and have never been used in organic EL devices.

Arylamine compounds having a substituted carbazole structure have been proposed as compounds having improved properties such as heat resistance and hole injectability (see, for example, Patent Literatures 4 and 5). Devices using these compounds for the hole injection layer or hole transport layer are improved in terms of heat resistance and luminous efficiency, but these improvements are still insufficient, and there are further demands for even lower driving voltage and higher luminous efficiency.

There is also a demand for devices capable of achieving highly efficient hole-electron recombination and having high luminous efficiency, low driving voltage, and long lifetime, which employ, in combination, materials having excellent hole/electron injectability and transportability, thin film stability and durability, in order to improve the properties of organic EL devices and enhance the yield in producing such devices.

Further, there is also a demand for devices having good carrier balance, high efficiency, low driving voltage, and long lifetime, which employ, in combination, materials having excellent hole/electron injectability and transportability, thin film stability and durability, in order to improve the properties of organic EL devices.

### Citation List

### Patent Literature

Patent Literature 1: US5792557
Patent Literature 2: US5639914
Patent Literature 3: US7799492
Patent Literature 4: US8021764
Patent Literature 5: US8394510
Patent Literature 6: Korean Patent Application Unexamined Publication No. 10-2018-0051356
Patent Literature 7: EP2684932

### Non-Patent Literature

Non-Patent Literature 1: Japan Society of Applied Physics, Preprints for 9th Lecture, pp. 55-61 (2001)
Non-Patent Literature 2: Japan Society of Applied Physics, Preprints for 9th Lecture, pp. 23-31 (2001)
Non-Patent Literature 3: Appl. Phys. Let., 98, 083302 (2011)
Non-Patent Literature 4: Japan OLED Forum, Preprints for 3rd Regular Meeting, pp. 13-14 (2006)

### Summary of Invention

An objective of the present invention is to provide an organic EL device having high efficiency, low driving voltage and long lifetime by using a material for organic EL devices offering excellent hole injectability and transportability, electron blockability, stability in a thin-film state, and durability, and also by employing, in combination, the aforementioned material and various other materials for organic EL devices offering excellent hole/electron injectability and transportability, electron blockability, stability in a thin-film state, and durability, in a manner that the properties of each of the materials can be brought out effectively.

Examples of physical properties to be possessed by an organic compound to be used in the present invention may include: (1) excellent hole injection properties; (2) high hole mobility; (3) excellent stability in a thin-film state; and (4) excellent heat resistance. Further, examples of physical properties to be possessed by an organic EL device provided by the present invention may include: (1) high luminous efficiency and power efficiency; (2) low practical driving voltage; and (3) long lifetime.

To achieve the aforementioned objectives, Inventors focused on the fact that triarylamine compounds have excellent hole injectability and transportability as well as thin film stability and durability, and diligently studied various triarylamine compounds, and thus arrived at the finding that, by using a triarylamine compound having a specific structure as a material for a hole transport layer, holes injected from the anode side can be transported efficiently, thereby accomplishing the present invention.

That is, the present invention provides an organic EL device described as follows.
{1} An organic electroluminescence device comprising, between an anode and a cathode, at least
   a hole transport layer,
   a light-emitting layer, and
   an electron transport layer

   in this order from the anode side, wherein
   the hole transport layer contains a triarylamine compound represented by general formula (1) below: 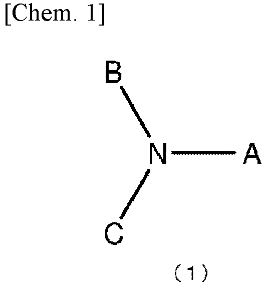
   (in the formula, A represents a monovalent group represented by general formula (2-1) below;
   B represents a substituted or unsubstituted aromatic hydrocarbon group, a substituted or unsubstituted aromatic heterocyclic group, or a substituted or unsubstituted fused aromatic group; and
   C represents a monovalent group represented by general formula (2-1) below, a substituted or unsubstituted aromatic hydrocarbon group, a substituted or unsubstituted aromatic heterocyclic group, or a substituted or unsubstituted fused aromatic group); 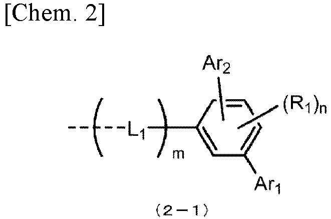
   (in the formula, the broken line represents a bonding site;
   Ri represents a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
   n is the number of R₁ and represents an integer from 0 to 3, wherein, when n is 2 or 3, the plurality of Ris bonded to the same benzene ring may be the same or different from one another and may be bonded to each other via a single bond, a substituted or unsubstituted methylene group, an oxygen atom, or a sulfur atom, to form a ring;
   Li represents a divalent group of a substituted or unsubstituted aromatic hydrocarbon or of a substituted or unsubstituted aromatic heterocycle or of a substituted or unsubstituted fused polycyclic aromatic;
   m is the number of L₁ and represents an integer from 1 to 3, wherein, when m is 2 or 3, Li may be the same or different from one another; and
   An and Ar₂ may be the same or different from one another and each represent a substituted or unsubstituted aromatic hydrocarbon group, a substituted or unsubstituted aromatic heterocyclic group, or a substituted or unsubstituted fused polycyclic aromatic group).

The organic electroluminescence device as set forth in clause {1}, wherein the monovalent group represented by the general formula (2-1) is a monovalent group represented by general formula (2-2) below. 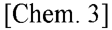 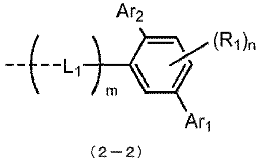 (In the formula, An, Ar₂, Li, m, n, and R₁ have same definitions as those in the general formula (2-1).)

{3} The organic electroluminescence device as set forth in clause {1}, wherein the monovalent group represented by the general formula (2-1) is a monovalent group represented by general formula (2-3) below. 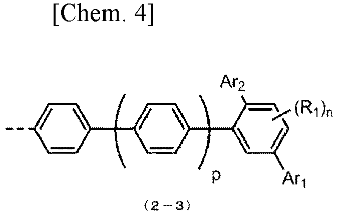
(In the formula, An, Ar₂, n, and R₁ have same definitions as those in the general formula (2-1); and
p represents 0 or 1.)

{4} The organic electroluminescence device as set forth in clause {1}, wherein the monovalent group represented by the general formula (2-1) is a monovalent group represented by general formula (2-4) below. 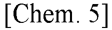 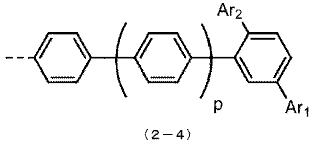
(In the formula, An and Ar₂ have same definitions as those in the general formula (2-1); and
p represents 0 or 1.)

{5} The organic electroluminescence device as set forth in any one of clauses {1} to {4}, wherein:
the hole transport layer is constituted by two layers including a first hole transport layer and a second hole transport layer; and
the first hole transport layer contains the triarylamine compound represented by the general formula (1).

Concrete examples of the "aromatic hydrocarbon group", "aromatic heterocyclic group", or "fused polycyclic aromatic group" in the "substituted or unsubstituted aromatic hydrocarbon group", "substituted or unsubstituted aromatic heterocyclic group", or "substituted or unsubstituted fused polycyclic aromatic group" as represented by Ri in general formulas (2-1) to (2-3) may include a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, a carbolinyl group, etc., or may be selected from aryl groups having 6 to 30 carbon atoms or hetero aryl groups having 2 to 30 carbon atoms.

Concrete examples of the "aryloxy group" in the "substituted or unsubstituted aryloxy group" as represented by Ri in general formulas (2-1) to (2-3) may include a phenyloxy group, a biphenylyloxy group, a terphenylyloxy group, a naphthyloxy group, an anthracenyloxy group, a phenanthrenyloxy group, a fluorenyloxy group, an indenyloxy group, a pyrenyloxy group, a perylenyloxy group, etc.

Concrete examples of the "linear or branched alkyl group having 1 to 6 carbon atoms", "cycloalkyl group having 5 to 10 carbon atoms", or "linear or branched alkenyl group having 2 to 6 carbon atoms" in the "linear or branched alkyl group having 1 to 6 carbon atoms and optionally having a substituent", "cycloalkyl group having 5 to 10 carbon atoms and optionally having a substituent", or "linear or branched alkenyl group having 2 to 6 carbon atoms and optionally having a substituent" as represented by Ri in general formulas (2-1) to (2-3) may include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a cyclopentyl group, a cyclohexyl group, a 1-adamantyl group, a 2-adamantyl group, a vinyl group, an allyl group, an isopropenyl group, a 2-butenyl group, etc.

Concrete examples of the "linear or branched alkyloxy group having 1 to 6 carbon atoms" or "cycloalkyloxy group having 5 to 10 carbon atoms" in the "linear or branched alkyloxy group having 1 to 6 carbon atoms and optionally having a substituent" or "cycloalkyloxy group having 5 to 10 carbon atoms and optionally having a substituent" as represented by Ri in general formulas (2-1) to (2-3) may include a methyloxy group, an ethyloxy group, a n-propyloxy group, an isopropyloxy group, a n-butyloxy group, a tert-butyloxy group, a n-pentyloxy group, a n-hexyloxy group, a cyclopentyloxy group, a cyclohexyloxy group, a cycloheptyloxy group, a cyclooctyloxy group, a 1-adamantyloxy group, a 2-adamantyloxy group, etc.

Concrete examples of the "substituent" in the "substituted aromatic hydrocarbon group", "substituted aromatic heterocyclic group", "substituted fused polycyclic aromatic group", "substituted aryloxy group", "linear or branched alkyl group having 1 to 6 carbon atoms and optionally having a substituent", "cycloalkyl group having 5 to 10 carbon atoms and optionally having a substituent", "linear or branched alkenyl group having 2 to 6 carbon atoms and optionally having a substituent", "linear or branched alkyloxy group having 1 to 6 carbon atoms and optionally having a substituent", or "cycloalkyloxy group having 5 to 10 carbon atoms and optionally having a substituent" as represented by Ri in general formulas (2-1) to (2-3) may include: a deuterium atom; a cyano group; a nitro group; halogen atoms, such as a fluorine atom, a chlorine atom, a bromine atom, or an iodine atom; silyl groups, such as a trimethylsilyl group, triphenylsilyl group, etc.; linear or branched alkyl groups having 1 to 6 carbon atoms, such as a methyl group, an ethyl group, a propyl group, etc.; linear or branched alkyloxy groups having 1 to 6 carbon atoms, such as a methyloxy group, an ethyloxy group, a propyloxy group, etc.; alkenyl groups, such as a vinyl group, an allyl group, etc.; aryloxy groups, such as a phenyloxy group, a tolyloxy group, etc.; arylalkyloxy groups, such as a benzyloxy group, a phenethyloxy group, etc.; aromatic hydrocarbon groups or fused polycyclic aromatic groups, such as a phenyl group, a biphenylyl group, a terphenylyl group, a naphthyl group, an anthracenyl group, a phenanthrenyl group, a fluorenyl group, a spirobifluorenyl group, an indenyl group, a pyrenyl group, a perylenyl group, a fluoranthenyl group, a triphenylenyl group, etc.; and aromatic heterocyclic groups, such as a pyridyl group, a thienyl group, a furyl group, a pyrrolyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzimidazolyl group, a pyrazolyl group, a dibenzofuranyl group, a dibenzothienyl group, a carbolinyl group, etc. These substituents may further be substituted by any of the substituents given as examples above. Further, the aforementioned substituent(s) and the substituted benzene ring, or a plurality of substituents substituting the same benzene ring, may be bonded to each other via a single bond, a substituted or unsubstituted methylene group, a substituted or unsubstituted amine group, an oxygen atom, or a sulfur atom, to form a ring.

Examples of the "substituted or unsubstituted aromatic hydrocarbon group", "substituted or unsubstituted aromatic heterocyclic group", and "substituted or unsubstituted fused polycyclic aromatic group" as represented by An and Ar₂ in general formulas (2-1) to (2-4) are the same as those for the "substituted or unsubstituted aromatic hydrocarbon group", "substituted or unsubstituted aromatic heterocyclic group", and "substituted or unsubstituted fused polycyclic aromatic group" as represented by Ri in the general formulas (2-1) to (2-3).

Examples of the "substituted or unsubstituted aromatic hydrocarbon group", "substituted or unsubstituted aromatic heterocyclic group", and "substituted or unsubstituted fused polycyclic aromatic group" as represented by B and C in general formula (1) are the same as those for the "substituted or unsubstituted aromatic hydrocarbon group", "substituted or unsubstituted aromatic heterocyclic group", and "substituted or unsubstituted fused polycyclic aromatic group" as represented by Ri in the general formulas (2-1) to (2-3).

Concrete examples of the "aromatic hydrocarbon", "aromatic heterocycle", or "fused polycyclic aromatic" of the "substituted or unsubstituted aromatic hydrocarbon", "substituted or unsubstituted aromatic heterocycle", or "substituted or unsubstituted fused polycyclic aromatic" in the "divalent group of a substituted or unsubstituted aromatic hydrocarbon or of a substituted or unsubstituted aromatic heterocycle or of a substituted or unsubstituted fused polycyclic aromatic" as represented by Li in general formulas (2-1) and (2-2) may include benzene, biphenyl, terphenyl, tetrakisphenyl, styrene, naphthalene, anthracene, acenaphthalene, fluorene, phenanthrene, indan, pyrene, triphenylene, pyridine, pyrimidine, triazine, pyrrole, furan, thiophen, quinoline, isoquinoline, benzofuran, benzothiophen, indoline, carbazole, carboline, benzoxazole, benzothiazole, quinoxaline, benzoimidazole, pyrazole, dibenzofuran, dibenzothiophen, naphthyridine, phenanthroline, acridine, etc.

The "divalent group of a substituted or unsubstituted aromatic hydrocarbon or of a substituted or unsubstituted aromatic heterocycle or of a substituted or unsubstituted fused polycyclic aromatic" represented by Li in general formulas (2-1) and (2-2) represents a divalent group that can be obtained by removing two hydrogen atoms from the aforementioned "aromatic hydrocarbon", "aromatic heterocycle", or "fused polycyclic aromatic". In cases where these divalent groups have a substituent, examples of the "substituent" may include the aforementioned examples given for the "substituent" of the "substituted aromatic hydrocarbon group", "substituted aromatic heterocyclic group", and "substituted fused polycyclic aromatic group" as represented by Ri in the general formulas (2-1) to (2-3), and they may take similar forms/configurations as those described above.

It is preferable that the monovalent group represented by general formula (2-1), as represented by A in general formula (1), is preferably a monovalent group represented by general formula (2-2), more preferably a monovalent group represented by general formula (2-3), and even more preferably a monovalent group represented by general formula (2-4).

It is preferable that An and Ar₂ in general formulas (2-1) to (2-4) are each a "substituted or unsubstituted aromatic hydrocarbon group" or "substituted or unsubstituted fused polycyclic aromatic group", more preferably a phenyl group, a naphthyl group or a biphenylyl group, either substituted or unsubstituted, and even more preferably an unsubstituted phenyl group or an unsubstituted naphthyl group.

It is preferable that B in general formula (1) is a "substituted or unsubstituted aromatic hydrocarbon group" or "substituted or unsubstituted fused polycyclic aromatic group", more preferably a phenyl group, a naphthyl group, a biphenylyl group, a phenanthrenyl group or a fluorenyl group, either substituted or unsubstituted.

It is preferable that C in general formula (1) is a "substituted or unsubstituted aromatic hydrocarbon group" or "substituted or unsubstituted fused polycyclic aromatic group", more preferably a phenyl group, a naphthyl group, a biphenylyl group, a phenanthrenyl group or a fluorenyl group, either substituted or unsubstituted.

The triarylamine compound represented by the general formula (1) to be used in the present invention has such properties as (1) excellent hole injection properties, (2) high hole mobility, (3) stability in a thin-film state, and (4) excellent heat resistance. Hence, the triarylamine compound can suitably be used as a constituent material of a hole transport layer of an organic EL device according to the present invention.

The organic EL device according to the present invention, which uses the triarylamine compound represented by the general formula (1) to be used in the present invention as a constituent material of a hole transport layer, can make the utmost effective use of the hole mobility of the triarylamine compound, and can thus achieve high efficiency, low driving voltage, and long lifetime, because it uses a triarylamine compound that has excellent amorphous properties and stability in a thin-film state.

Further, in the organic EL device of the present invention, in cases where the hole transport layer is constituted by two layers including a first hole transport layer and a second hole transport layer and the first hole transport layer contains the triarylamine compound represented by the general formula (1), it is possible to achieve an organic EL device having even higher efficiency and longer lifetime because movement of electrons can be inhibited in addition to achieving excellent hole injection properties.

### Brief Description of Drawings

[Fig. 1] Fig. 1 is a diagram illustrating structural formulas of Compounds 1-1 to 1-12 as examples of triarylamine compounds represented by general formula (1).
[Fig. 2] Fig. 2 is a diagram illustrating structural formulas of Compounds 1-13 to 1-24 as examples of triarylamine compounds represented by general formula (1).
[Fig. 3] Fig. 3 is a diagram illustrating structural formulas of Compounds 1-25 to 1-36 as examples of triarylamine compounds represented by general formula (1).
[Fig. 4] Fig. 4 is a diagram illustrating structural formulas of Compounds 1-37 to 1-48 as examples of triarylamine compounds represented by general formula (1).
[Fig. 5] Fig. 5 is a diagram illustrating structural formulas of Compounds 1-49 to 1-60 as examples of triarylamine compounds represented by general formula (1).
[Fig. 6] Fig. 6 is a diagram illustrating structural formulas of Compounds 1-61 to 1-72 as examples of triarylamine compounds represented by general formula (1).
[Fig. 7] Fig. 7 is a diagram illustrating structural formulas of Compounds 1-73 to 1-84 as examples of triarylamine compounds represented by general formula (1).
[Fig. 8] Fig. 8 is a diagram illustrating structural formulas of Compounds 1-85 to 1-96 as examples of triarylamine compounds represented by general formula (1).
[Fig. 9] Fig. 9 is a diagram illustrating structural formulas of Compounds 1-97 to 1-105 as examples of triarylamine compounds represented by general formula (1).
[Fig. 10] Fig. 10 is a diagram illustrating an example of a configuration of an organic EL device according to the present invention.

### Description of Embodiments

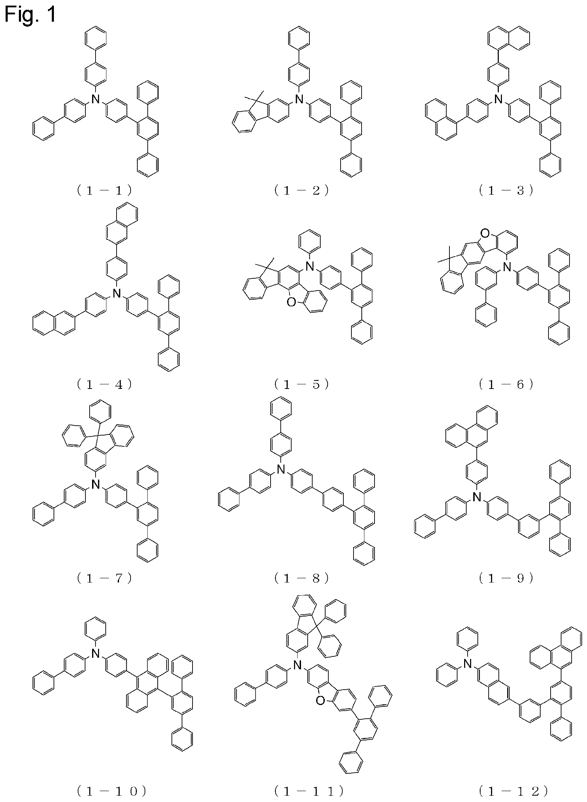

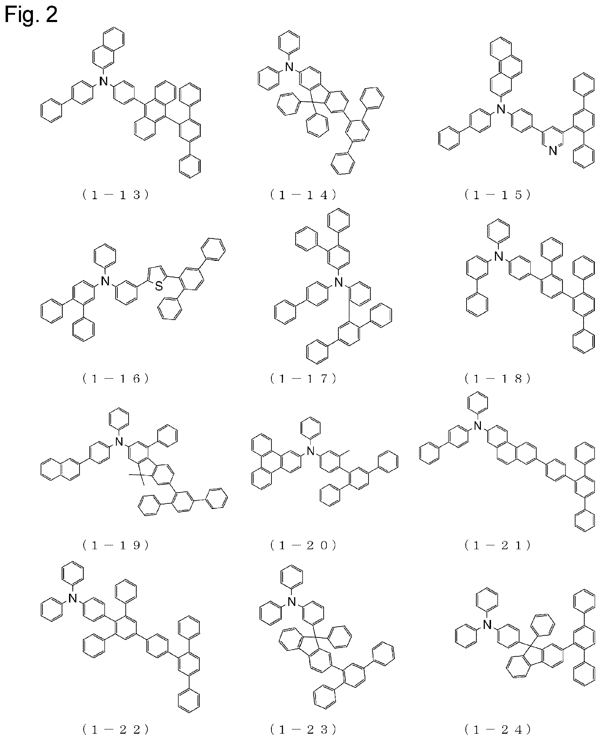

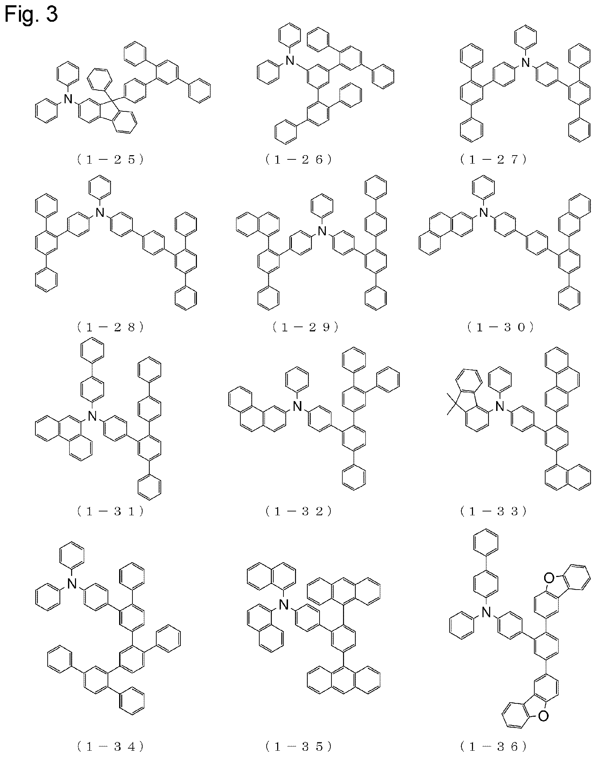

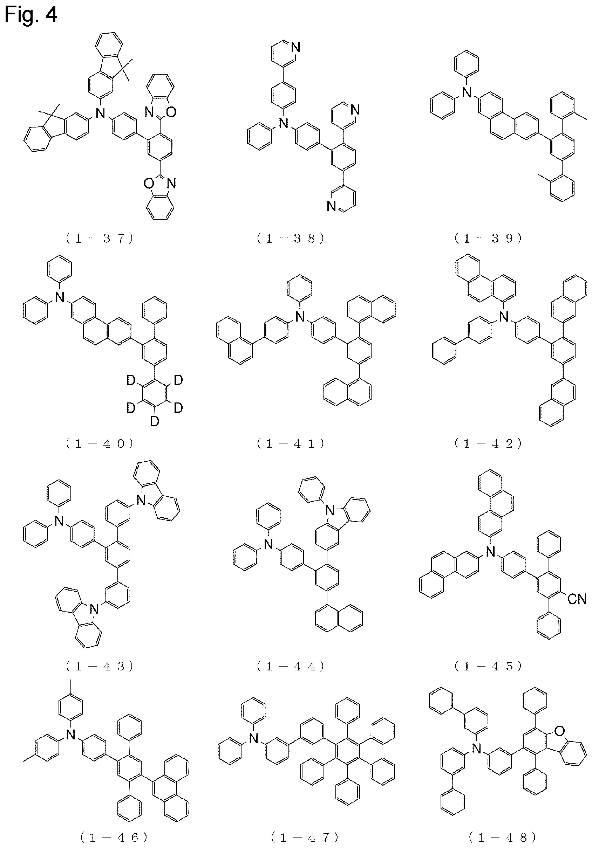

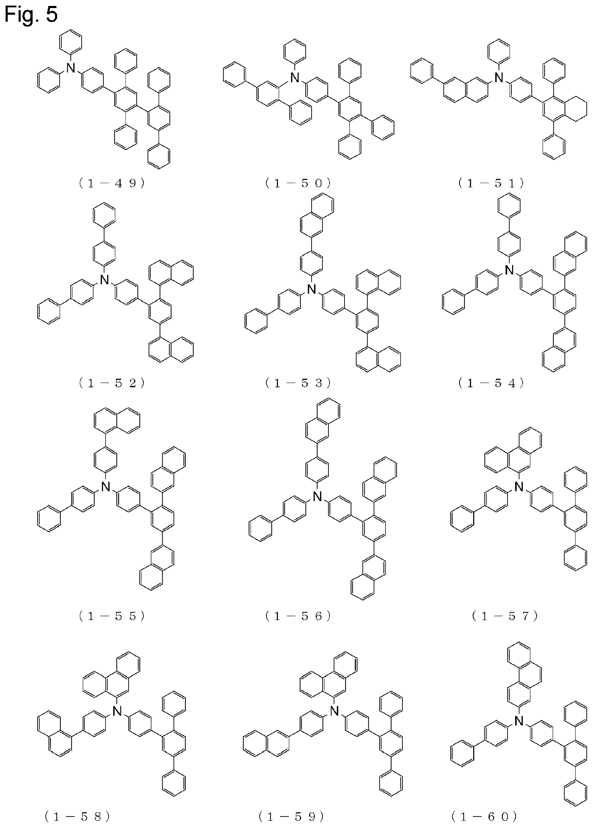

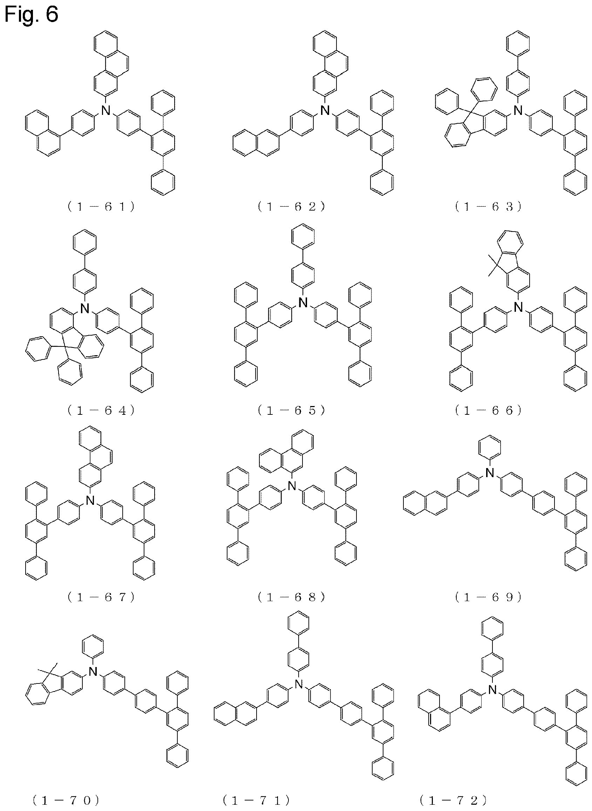

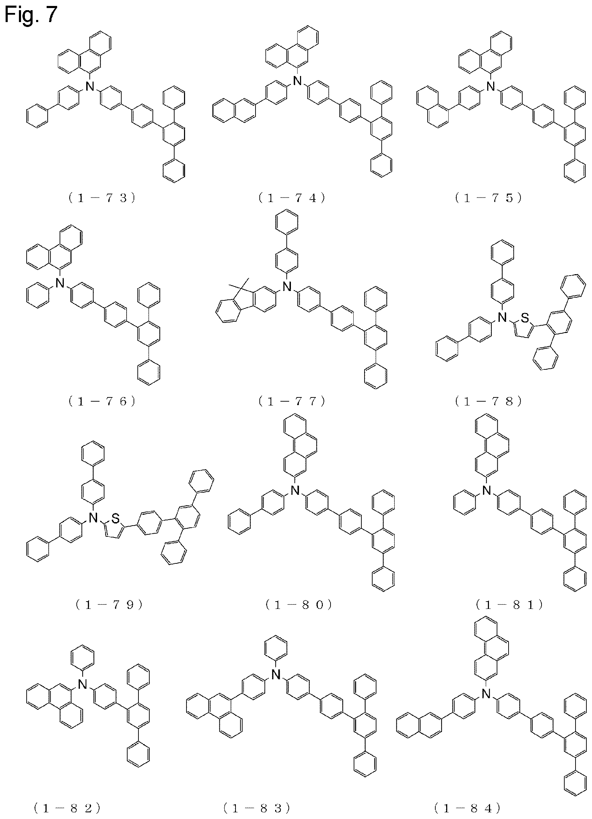

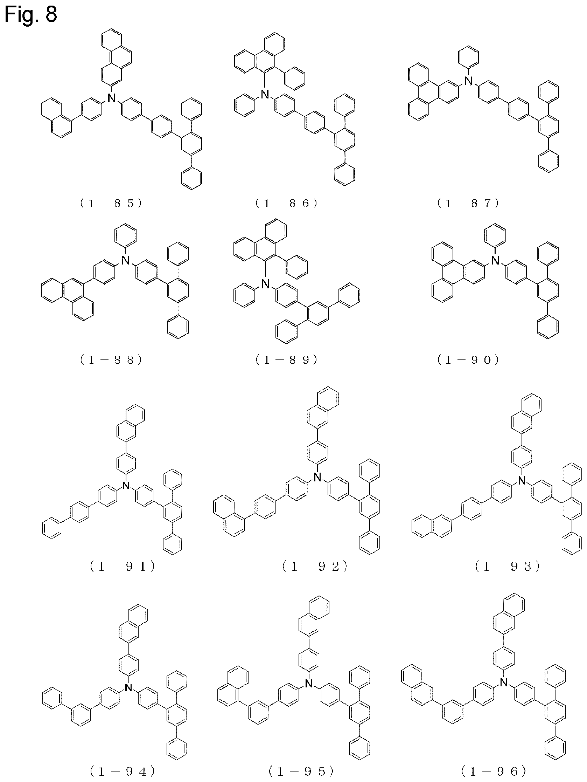

Figs. 1 to 9 illustrate concrete examples of preferred compounds among triarylamine compounds represented by the general formula (1), which may suitably be used for an organic EL device of the present invention. Note, however, that the compounds are not limited to the illustrated compounds.

The triarylamine compound represented by general formula (1) can be purified by methods, such as column chromatography purification, adsorption purification with silica gel, activated carbon, activated clay, etc., recrystallization or crystallization using a solvent, sublimation purification, or the like. Compound identification can be achieved by NMR analysis. It is preferable to measure such physical property values as the melting point, glass transition point (Tg), HOMO level (ionization potential), and the like. The melting point serves as an index of vapor deposition characteristics. The glass transition point (Tg) serves as an index of stability in a thin-film state. The HOMO level serves as an index of hole transportability and/or hole blockability. It is preferable that compounds to be used in the organic EL device of the present invention are purified by methods, such as column chromatography purification, adsorption purification with silica gel, activated carbon, activated clay, etc., recrystallization or crystallization using a solvent, sublimation purification, etc., and then ultimately purified by sublimation purification.

The melting point and glass transition point (Tg) can be measured, for example, with a high-sensitivity differential scanning calorimeter (DSC3100SA from Bruker AXS) using a powder.

The HOMO level can be found, for example, with an ionization potential measurement device (PYS-202 from Sumitomo Heavy Industries, Ltd.) by preparing a 100-nm thin film on an ITO substrate.

A structure of the organic EL device of the present invention may, for example, sequentially include, on a substrate, an anode, a hole transport layer, a light-emitting layer, an electron transport layer, and a cathode. In other examples, a hole injection layer may be provided between the anode and the hole transport layer, or a hole blocking layer may be provided between the light-emitting layer and the electron transport layer, or an electron injection layer may be provided between the electron transport layer and the cathode. In such multilayer structures, for example, a single layer may have functions of the hole injection layer and the hole transport layer, or functions of the electron injection layer and the electron transport layer. Further, it is possible to stack two or more organic layers having the same function; for example, the structure may include: two stacked hole transport layers; two stacked light-emitting layers; or two stacked electron transport layers.

As for the structure of the organic EL device of the present invention, it is preferable that the hole transport layer is constituted by two layers including a first hole transport layer and a second hole transport layer. To mainly achieve the function of transporting the injected holes to the light-emitting layer efficiently, it is preferable that the first hole transport layer contains the triarylamine compound represented by the general formula (1) which has a suitable energy level and excellent hole transportability, and is more preferably constituted by the triarylamine compound represented by the general formula (1). Further, to achieve the function of preventing the electrons in the light-emitting layer from passing therethrough to the hole transport layer side, it is preferable that the second hole transport layer is adjacent to the light-emitting layer and has the function as an electron blocking layer. The blocking of electrons is also closely related to device life. More specifically, with the structure of the organic EL device of the present invention, holes can be injected to the light-emitting layer more efficiently and also the electrons injected from the electron transport layer to the light-emitting layer can be confined within the light-emitting layer. Thus, the luminous efficiency and longevity of the device can be further improved.

For the anode in the organic EL device of the present invention, it is possible to use an electrode material having a large work function, such as ITO or gold. For the hole injection layer in the organic EL device of the present invention, it is possible to use, for example: a triphenylamine material such as starburst-type triphenylamine derivatives, various triphenylamine tetramers, etc.; a porphyrin compound typified by copper phthalocyanine; an acceptor heterocyclic compound such as hexacyanoazatriphenylene; or a coating-type polymer material.

For the hole transport layer in the organic EL device of the present invention, the triarylamine compound represented by the general formula (1) is used as a hole-transportable material. In cases where the hole transport layer is constituted by two layers including a first hole transport layer and a second hole transport layer, it is preferable that the triarylamine compound represented by the general formula (1) is used only in the first hole transport layer. As for other hole-transportable materials that may be mixed with, or be used simultaneously with, the triarylamine compound represented by the general formula (1), it is possible to use, for example: a benzidine derivative, such as N,N'-diphenyl-N,N'-di(m-tolyl) benzidine ("TPD"), N,N'-diphenyl-N,N'-di(α-naphthyl) benzidine ("NPD"), N,N,N',N'-tetrabiphenylylbenzidine, etc.; 1,1-bis[4-(di-4-tolylamino)phenyl]cyclohexane ("TAPC"); triarylamine compounds; or other compounds such as various triphenylamine derivatives.

For the hole injection layer and the first hole transport layer, it is possible to use, for example: materials ordinarily used for such layers and p-doped with, for example, trisbromophenylamine hexachloroantimonate or a radialene derivative (see, for example, Patent Literature 7); or polymer compounds having, as a partial structure thereof, a benzidine derivative structure such as TPD.

Examples of materials that may be used for the second hole transport layer in the organic EL device of the present invention may include, for example, compounds having an electron blocking action, such as: a carbazole derivative, such as 4,4',4"-tri(N-carbazolyl)triphenylamine ("TCTA"), 9,9-bis[4-(carbazol-9-yl)phenyl]fluorene, 1,3-bis(carbazol-9-yl)benzene ("mCP"), 2,2-bis(4-carbazol-9-ylphenyl)adamantane ("Ad-Cz"), etc.; or a compound containing a triarylamine structure and a triphenylsilyl group typified by 9-[4-(carbazol-9-yl)phenyl]-9-[4-(triphenylsilyl)phenyl]-9H-fluorene, etc.

For the light-emitting layer in the organic EL device of the present invention, it is possible to use, for example, a metal complex of a quinolinol derivative, e.g., Alq₃, as well as various other metal complexes, an anthracene derivative, a bisstyrylbenzene derivative, a pyrene derivative, an oxazole derivative, a poly(para-phenylene vinylene) derivative, etc. The light-emitting layer may be constituted by a host material and a dopant material. For the host material, an anthracene derivative may preferably be used, and also, in addition to the aforementioned light-emitting materials, it is possible to use, for example, a heterocyclic compound having an indole ring as a partial structure of a fused ring, a heterocyclic compound having a carbazole ring as a partial structure of a fused ring, a carbazole derivative, a thiazole derivative, a benzimidazole derivative, a polydialkylfluorene derivative, etc. For the dopant material, it is possible to use, for example, a pyrene derivative, quinacridone, coumarin, rubrene, perylene, a derivative of the above, a benzopyran derivative, an indenophenanthrene derivative, a rhodamine derivative, an aminostyryl derivative, etc.

It is also possible to use a phosphorescent substance for the light-emitting material. For the phosphorescent substance, it is possible to use a phosphorescent substance such as a metal complex of iridium, platinum, etc. Examples may include green phosphorescent substances such as Ir(ppy)₃ etc., blue phosphorescent substances such as FIrpic, FIr6, etc., and red phosphorescent substances such as Btp₂Ir(acac) etc. As regards host materials, for the hole injecting/transporting host material, it is possible to use, for example, a carbazole derivative such as 4,4'-di(N-carbazolyl)biphenyl ("CBP"), TCTA, mCP, etc. For the electron-transporting host material, it is possible to use, for example, p-bis(triphenylsilyl)benzene ("UGH2"), 2,2',2"-(1,3,5-phenylene)-tris(1-phenyl-1H-benzimidazole) ("TPBI"), etc.

To avoid concentration quenching, doping of the host material(s) with a phosphorescent light-emitting material is preferably performed by co-vapor deposition within a range of 1 to 30 wt.% with respect to the entire light-emitting layer.

Further, for the light-emitting material, it is possible to use a material emitting delayed fluorescence, e.g., PIC-TRZ, CC2TA, PXZ-TRZ, a CDCB derivative such as 4CzIPN, etc. (see, for example, Non-Patent Literature 3).

For the hole blocking layer in the organic EL device of the present invention, it is possible to use a compound having a hole blocking action, with examples including phenanthroline derivatives such as bathocuproine ("BCP"), metal complexes of a quinolinol derivative such as bis(2-methyl-8-quinolinato))-4-phenylphenolato aluminum (III) (abbreviated hereinbelow as "BAlq"), various rare-earth complexes, triazole derivatives, triazine derivatives, oxadiazole derivatives, etc. These materials may also serve as materials for the electron transport layer.

For the electron transport layer in the organic EL device of the present invention, it is possible to use a metal complex of a quinolinol derivative such as Alq₃, BAlq, etc., one of various metal complexes, a triazole derivative, a triazine derivative, an oxadiazole derivative, a pyridine derivative, a pyrimidine derivative, a benzimidazole derivative, a thiadiazole derivative, an anthracene derivative, a carbodiimide derivative, a quinoxaline derivative, a pyridoindole derivative, a phenanthroline derivative, a silole derivative, etc.

For the electron injection layer in the organic EL device of the present invention, it is possible to use an alkali metal salt such as lithium fluoride, cesium fluoride, etc., an alkaline-earth metal salt such as magnesium fluoride etc., a metal complex of a quinolinol derivative such as quinolinol lithium etc., a metal oxide such as aluminum oxide etc., or a metal such as ytterbium (Yb), samarium (Sm), calcium (Ca), strontium (Sr), cesium (Cs), etc. The electron injection layer may, however, be omitted by suitable selection of the electron transport layer and the cathode.

In the electron injection layer or the electron transport layer, it is possible to use a material ordinarily used for such layers and further n-doped with a metal such as cesium etc.

For the cathode in the organic EL device of the present invention, an electrode material having a low work function, such as aluminum etc., or an alloy having an even lower work function, such as magnesium silver alloy, magnesium indium alloy, aluminum magnesium alloy, etc., may be used as the electrode material.

These materials to be used in the respective layers constituting the organic EL device of the present invention may each be formed into a film singly, or may be mixed with other materials and formed into a film which may be used as a single layer. It is also possible to form a laminate structure constituted by layers each formed singly by the respective materials, or constituted by layers formed by mixing a plurality of materials, or constituted by layers each formed singly by the respective materials and also layers formed by mixing a plurality of materials. These materials can form thin films by known methods, such as vapor deposition, spin coating, ink-jetting, etc.

### Examples

Embodiments of the present invention will be described in further detail below according to working examples. Note, however, that the present invention is not limited to the following examples.

### Synthesis Example 1:

### Synthesis of bis(4-naphthalen-2-yl-phenyl)-(2',5'-diphenyl-biphenyl-4-yl)-amine (1-4):

A reaction vessel was charged with 10.0 g of bis(4-naphthalen-2-yl-phenyl)-amine, 11.0 g of 4-bromo-2',5'-diphenyl-biphenyl, 0.1 g of palladium(II) acetate, 0.2 g of tri(t-butyl)phosphine, and 2.7 g of sodium t-butoxide, and the mixture was stirred under reflux for 3 hours in a toluene solvent. After the mixture was allowed to cool, a filtrate obtained by filtering was concentrated, to obtain a crude product. The obtained crude product was purified by crystallization with a toluene/acetone mixed solvent, to obtain 9.0 g of a white powder of bis(4-naphthalen-2-yl-phenyl)-(2',5'-diphenyl-biphenyl-4-yl)-amine (1-4) (yield: 52.3%).

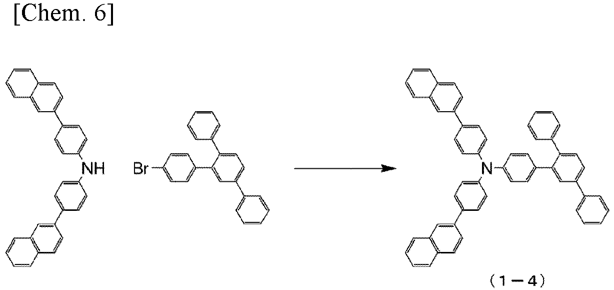

The structure of the obtained white powder was identified by detecting the following 39 hydrogen signals by ¹H-NMR (CDCl₃).

δ (ppm) = 8.06 (2H), 7.92 (6H), 7.78 (4H), 7.73 (1H), 7.68 (5H), 7.53 (7H), 7.42 (1H), 7.39-7.23 (9H), 7.14 (4H).

### Synthesis Example 2:

### Synthesis of (2',5' -diphenyl-biphenyl-4-yl)-(4-naphthalen-1-yl-phenyl)-phenanthren-9-yl-amine (1-58):

A reaction vessel was charged with 8.5 g of (2',5'-diphenyl-biphenyl-4-yl)-(4-naphthalen-1-yl-phenyl)-amine, 4.8 g of 9-bromo-phenanthrene, 0.1 g of palladium(II) acetate, 0.3 g of tri(t-butyl)phosphine, and 2.3 g of sodium t-butoxide, and the mixture was stirred under reflux for 3 hours in a toluene solvent. After the mixture was allowed to cool, a filtrate obtained by filtering was concentrated, to obtain a crude product. The obtained crude product was purified by crystallization with a toluene/acetone mixed solvent, to obtain 8.3 g of a white powder of (2',5'-diphenyl-biphenyl-4-yl)-(4-naphthalen-1-yl-phenyl)-phenanthren-9-yl-amine (1-58) (yield: 73.1%).

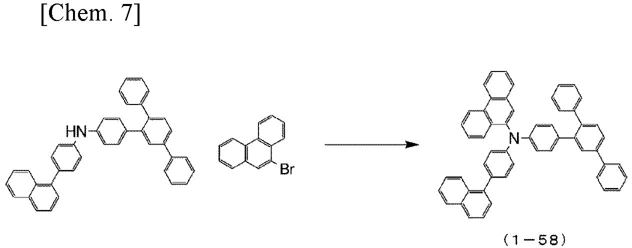

The structure of the obtained white powder was identified by detecting the following 37 hydrogen signals by ¹H-NMR (CDCl₃).

δ (ppm) = 8.79 (1H), 8.75 (1H), 8.14 (1H), 8.03 (1H), 7.92 (1H), 7.85 (2H), 7.72 (6H), 7.65 (2H), 7.60 (1H), 7.50 (7H), 7.42 (1H), 7.36 (3H), 7.27-7.18 (6H), 7.09 (4H).

### Synthesis Example 3:

### Synthesis of (2',5'-diphenyl-biphenyl-4-yl)-(4-naphthalen-2-yl-phenyl)-phenanthren-9-yl-amine (1-59):

A reaction vessel was charged with 8.0 g of (2',5'-diphenyl-biphenyl-4-yl)-(4-naphthalen-2-yl-phenyl)-amine, 4.5 g of 9-bromo-phenanthrene, 0.1 g of palladium(II) acetate, 0.2 g of tri(t-butyl)phosphine, and 2.2 g of sodium t-butoxide, and the mixture was stirred under reflux for 3 hours in a toluene solvent. After the mixture was allowed to cool, a filtrate obtained by filtering was concentrated, to obtain a crude product. The obtained crude product was purified by crystallization with a toluene/acetone mixed solvent, to obtain 6.6 g of a pale-yellow powder of (2',5'-diphenyl-biphenyl-4-yl)-(4-naphthalen-2-yl-phenyl)-phenanthren-9-yl-amine (1-59) (yield: 61.7%).

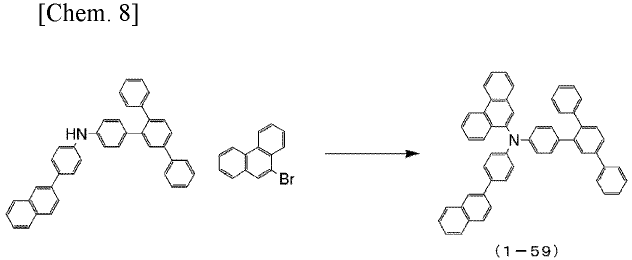

The structure of the obtained pale-yellow powder was identified by detecting the following 37 hydrogen signals by ¹H-NMR (CDCl₃).

δ (ppm) = 8.79 (1H), 8.74 (1H), 8.09 (1H), 8.01 (1H), 7.86 (4H), 7.75 (1H), 7.71 (5H), 7.66 (2H), 7.60 (3H), 7.50 (5H), 7.39 (1H), 7.34-7.23 (6H), 7.20 (2H), 7.07 (4H).

### Synthesis Example 4:

### Synthesis of (2",5"-diphenyl-[1,1';4',1"]terphenyl-4-yl)-(4-naphthalen-2-yl-phenyl)-phenyl-amine (1-69):

A reaction vessel was charged with 6.0 g of (4-naphthalen-2-yl-phenyl)-phenyl-amine, 10.3 g of 4-bromo-2",5"-diphenyl-[1,1';4',1"]terphenyl, 0.1 g of palladium(II) acetate, 0.2 g of tri(t-butyl)phosphine, and 2.3 g of sodium t-butoxide, and the mixture was stirred under reflux overnight in a toluene solvent. After the mixture was allowed to cool, a filtrate obtained by filtering was concentrated, to obtain a crude product. The obtained crude product was purified by column chromatography (adsorbent: silica gel; eluent: dichloromethane/n-heptane), to obtain 7.1 g of a white powder of (2",5"-diphenyl-[1,1';4',1"]terphenyl-4-yl)-(4-naphthalen-2-yl-phenyl)-phenyl-amine (1-69) (yield: 51.7%).

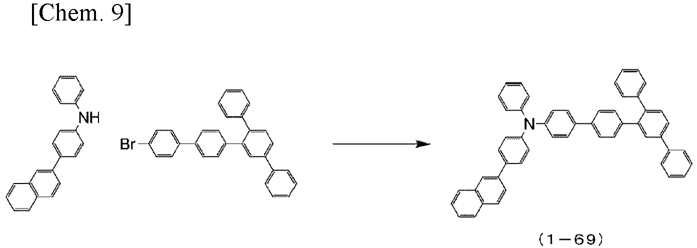

The structure of the obtained white powder was identified by detecting the following 37 hydrogen signals by ¹H-NMR (CDCl₃).

δ (ppm) = 8.04 (1H), 7.91 (3H), 7.73 (5H), 7.66 (2H), 7.56 (2H), 7.51 (7H), 7.42 (1H), 7.39-7.18 (15H), 7.10 (1H).

### Synthesis Example 5:

### Synthesis of (2",5"-diphenyl-[1,1';4',1"]terphenyl-4-yl)-(4-phenanthren-9-yl-phenyl)-phenyl-amine (1-83):

A reaction vessel was charged with 11.0 g of (4-phenanthren-9-yl-phenyl)-phenyl-amine, 16.2 g of 4-bromo-2",5"-[1,1';4',1"]terphenyl, 0.1 g of palladium(II) acetate, 0.3 g of tri(t-butyl)phosphine, and 3.7 g of sodium t-butoxide, and the mixture was stirred under reflux overnight in a toluene solvent. After the mixture was allowed to cool, a filtrate obtained by filtering was concentrated, to obtain a crude product. The obtained crude product was purified by column chromatography (adsorbent: silica gel; eluent: dichloromethane/n-heptane), to obtain 11.2 g of a white powder of (2",5"-diphenyl-[1,1' ;4',1"]terphenyl-4-yl)-(4-phenanthren-9-yl-phenyl)-phenyl-amine (1-83) (yield: 48.5%).

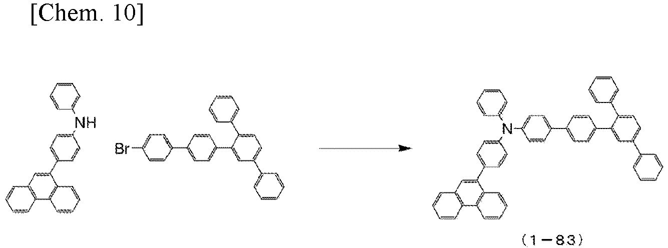

The structure of the obtained white powder was identified by detecting the following 39 hydrogen signals by ¹H-NMR (CDCl₃).

δ (ppm) = 8.81 (1H), 8.75 (1H), 8.09 (1H), 7.93 (1H), 7.71 (7H), 7.65-7.44 (10H), 7.44-7.22 (17H), 7.11 (1H).

### Synthesis Example 6:

### Synthesis of N-(3'-(naphthalen-2-yl)-[1,1'-biphenyl]-4-yl)-N-(4-(naphthalene)-2-yl)phenyl)-5'-phenyl -[1,1':2',1"-terphenyl]-4-amine (1-96):

A reaction vessel was charged with 50.0 g of 4-bromoaniline, 113.9 g of 4,4,5,5-tetramethyl-2-[1,1':4',1"-terphenyl]-2'-yl-1,3,2-dioxaborolane, 350 mL of toluene, 88 mL of ethanol, 80.4 g of potassium carbonate, and 290 mL of water, then 6.7 g of tetrakis(triphenylphosphine)palladium was added thereto, and the mixture was stirred under reflux for 14 hours. After the mixture was allowed to cool, the mixture was separated, and the organic layer was sequentially washed with water and saturated saline solution, and was then dried with anhydrous magnesium sulfate. The desiccant was removed by filtration, and the filtrate was concentrated. Then, 450 mL of heptane was added to the residue and was stirred overnight at room temperature, and the solid was collected by filtration, to obtain 77.8 g of a yellowish-white powder of [1,1':2',1":4",1‴-quaterphenyl]-4-amine (yield: 83.3%).

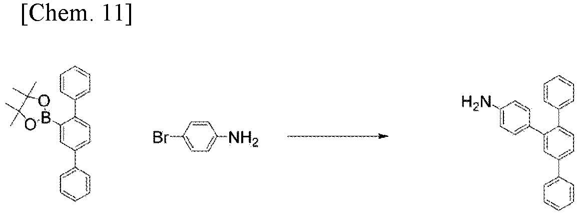

A reaction vessel was charged with 55.0 g of [1,1':2',1":4",1‴-quaterphenyl]-4-amine, 74.9 g of 2-(4-bromophenyl)naphthalene, 28.0 g of sodium t-butoxide, 420 mL of toluene, 0.9 g of tris(dibenzylideneacetone)dipalladium, and 2.4 g of 2,2'-bis(diphenylphosphino)-1,1'-binaphthyl, and the mixture was stirred under reflux for 15 hours. The mixture was cooled to 80°C, and the solid was removed by hot filtration using a celite-padded funnel. The filtrate was heated and stirred, then 50 g of silica gel was added at 80°C and was stirred for 1 hour, and the solid was removed by hot filtration. The filtrate was concentrated, and the residue was recrystallized with a toluene/acetone mixed solvent, to obtain 69.5 g of a yellowish-white powder of N-(4-(2-naphthyl)phenyl)-[1,1':2',1 ":4",1‴-quaterphenyl]-4-amine (yield: 68.3%).

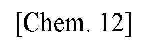

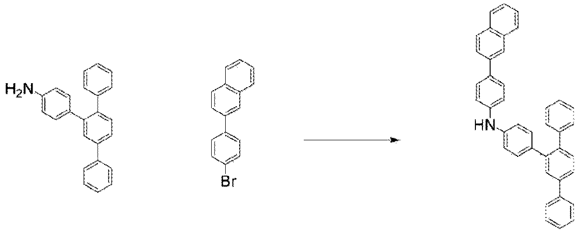

A reaction vessel was charged with 69.5 g of N-(4-(2-naphthyl)phenyl)-[1,1':2',1":4",1‴,-quaterphenyl]-4-amine, 45.1 g of 1-bromo-4-iodobenzene, 25.7 g of sodium t-butoxide, 700 mL of toluene, 2.5 g of copper iodide, and 2.3 g of N,N'-dimethylethylenediamine, and the mixture was stirred under reflux for 16 hours. The mixture was cooled to 80°C, and the solid was removed by hot filtration using a celite-padded funnel. The filtrate was concentrated, and the residue was purified by column chromatography (adsorbent: silica gel; eluent: dichloromethane/n-heptane), to obtain 59.4 g of a yellowish-white powder of N-(4-bromophenyl)-N-(4-(2-naphthyl)phenyl)-[1,1':2',1":4",1‴-quaterphenyl]-4-amine (yield: 65.5%).

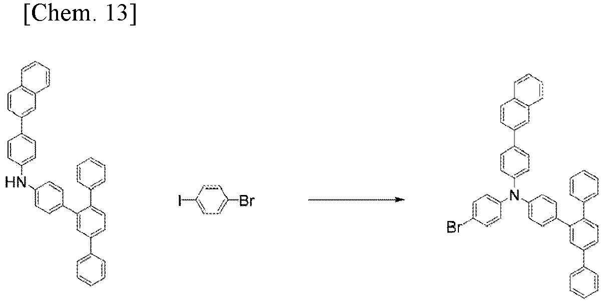

A reaction vessel was charged with 12.0 g of N-(4-bromophenyl)-N-(4-(2-naphthyl)phenyl)-[1,1':2',1" :4",1‴-quaterphenyl]-4-amine, 5.3 g of 3-(2-naphthyl)phenylboronic acid, 84 mL of toluene, 21 mL of ethanol, 4.9 g of potassium carbonate, and 18 mL of water, then 0.4 g of tetrakis(triphenylphosphine)palladium was added thereto, and the mixture was stirred under reflux for 14 hours. After the mixture was allowed to cool, 84 mL of methanol was added, and the precipitated solid was collected by filtration. To the solid, 70 mL of water and 70 mL of methanol were added, and dispersion washing was performed for 1 hour under reflux. The solid was collected by filtration, then 140 mL of toluene was added thereto, and this was once heated to 100°C to remove water and methanol. The mixture was then cooled to 80°C, and 7 g of silica gel and 7 g of activated clay were added thereto and stirred for 1 hour. The solid was removed by filtration, and the filtrate was concentrated. Then, 140 mL of acetone was added to the residue and was stirred overnight at room temperature, and the solid was collected by filtration. The solid was recrystallized with a toluene/acetone mixed solvent, to obtain 11.3 g of a yellowish-white powder of N-(3'-(naphthalen-2-yl)-[1,1'-biphenyl]-4-yl)-N-(4-(naphthalene)-2-yl)phenyl)-5'-phenyl -[1,1':2',1"-terphenyl]-4-amine (yield: 79.6%).

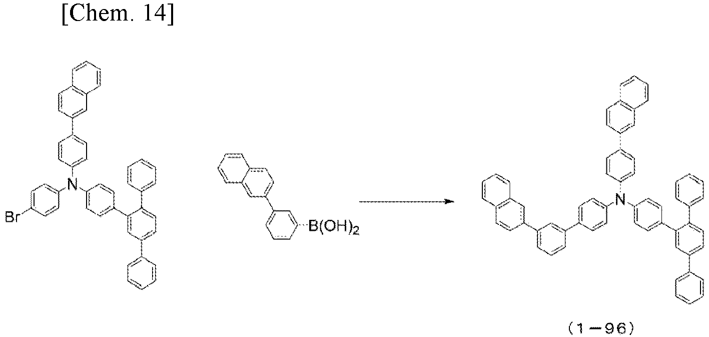

The structure of the obtained yellowish-white powder was identified by detecting the following 43 hydrogen signals by ¹H-NMR (CDCl₃).

δ (ppm) = 8.09 (1H), 8.01 (1H), 7.77-7.92 (8H), 7.43-7.73 (19H), 7.21-7.38 (10H), 7.04-7.13 (4H).

### Synthesis Example 7:

### Synthesis of N,9,9-triphenyl-N-(4'-phenyl-[1,1':2',1":4",1‴-quaterphenyl]-4‴-yl)-9H-fluorene-2-am ine (1-97):

A reaction vessel was charged with 20.0 g of 2'-chloro-[1,1':4',1"-terphenyl], 29.5 g of N-phenyl-4'-(4,4,5,5-tetramethyl-1,3,2-dioxaborolane-2-yl)-[1,1'-biphenyl]-4-amine, 200 mL of 1,4-dioxane, 32.1 g of potassium phosphate, and 60 mL of water, then 2.1 g of tris(dibenzylideneacetone)dipalladium and 2.1 g of tricyclohexyl phosphine were further added thereto, and the mixture was stirred under reflux for 14 hours. After the mixture was allowed to cool, 200 mL of methanol was added, and the precipitated solid was collected by filtration. Then, 360 mL of chlorobenzene was added to the solid, and this was once heated to 100°C. This was then cooled to 80°C, and 9 g of silica gel and 9 g of activated clay were added thereto and stirred for 1 hour. The solid was removed by filtration, and the filtrate was concentrated. Then, 360 mL of acetone was added to the residue and was stirred overnight at room temperature, and the solid was collected by filtration, to obtain 30.6 g of a yellowish-white powder of N,4'-diphenyl-[1,1':2',1":4",1‴-terphenyl]-4‴-amine (yield: 85.5%).

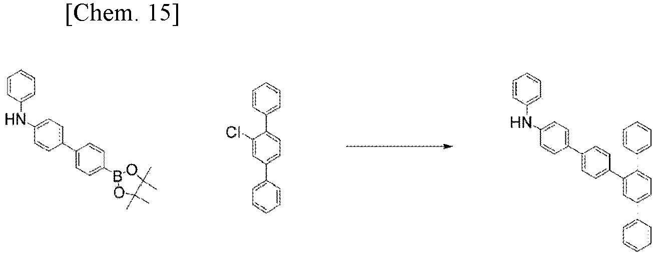

A reaction vessel was charged with 20.0 g of N,4'-diphenyl-[1,1' :2',1":4",1‴-terphenyl]-4‴-amine, 18.5 g of 2-bromo-9,9-diphenyl-9H-fluorene, 200 mL of toluene, and 6.1 g of sodium t-butoxide, then 0.1 g of tris(dibenzylideneacetone)dipalladium and 0.2 g of a 50% toluene solution of tri(t-butyl)phosphine were added thereto, and the mixture was stirred under reflux for 14 hours. The mixture was cooled to 80°C, and then hot filtration was performed using a celite-padded funnel to remove the solid. The filtrate was heated and stirred, and then 12 g of silica gel and 12 g of activated clay were added thereto at 80°C and stirred for 1 hour. The solid was removed by filtration, and the filtrate was concentrated. The residue was recrystallized with a toluene/acetone mixed solvent, to obtain 21.4 g of a yellowish-white powder of N,9,9-triphenyl-N-(4'-phenyl-[1,1':2',1":4",1‴-quaterphenyl]-4‴-yl)-9H-fluorene-2-am ine (1-97) (yield: 64.1%).

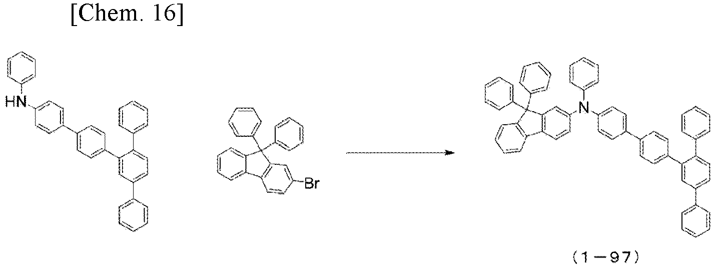

The structure of the obtained yellowish-white powder was identified by detecting the following 43 hydrogen signals by ¹H-NMR (CDCl₃).

δ (ppm) = 7.64-7.71 (5H), 7.58-7.60 (1H), 7.51-7.53 (1H), 7.41-7.48 (6H), 7.30-7.38 (3H), 7.14-7.24 (21H), 6.98-7.09 (6H).

### Synthesis Example 8:

### Synthesis of N-([1,1'-biphenyl]-4-yl)-5'-(naphthalen-2-yl)-N-(4-(naphthalen-2-yl)phenyl)-[1,1':2',1"-terphenyl]-4-amine (1-102):

A reaction vessel was charged with 31.0 g of 4-bromo-2-chloro-1,1'-biphenyl, 22.0 g of 2-naphthaleneboronic acid, 240 mL of toluene, 60 mL of ethanol, 24.1 g of potassium carbonate, and 80 mL of water, then 1.3 g of tetrakis(triphenylphosphine)palladium was added thereto, and the mixture was stirred under reflux for 15 hours. After the mixture was allowed to cool, the mixture was separated, and the organic layer was washed with water. The organic layer was stirred and once heated to 100°C to confirm that no water is included. This was then cooled to 80°C and 20 g of silica gel was added thereto and stirred for 1 hour. The solid was removed by hot filtration, and the filtrate was concentrated. The residue was recrystallized with a toluene/heptane mixed solvent, to obtain 25.6 g of a gray powder of 2-(2-chloro-[1,1'-biphenyl]-4-yl)naphthalene (yield: 63.5%).

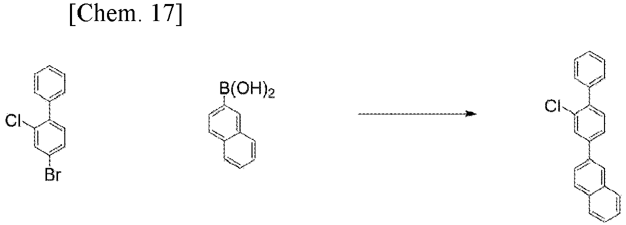

A reaction vessel was charged with 20.0 g of 2-(2-chloro-[1,1'-biphenyl]-4-yl)naphthalene, 24.8 g of N-(4-(4,4,5,5-tetramethyl-1,3,2-dioxaborolane-2-yl)phenyl)-[1,1'-biphenyl]-4-amine, 160 mL of 1,4-dioxane, 27.0 g of potassium phosphate, and 60 mL of water, then 1.8 g of tris(dibenzylideneacetone)dipalladium and 1.8 g of tricyclohexyl phosphine were added thereto, and the mixture was stirred under reflux for 12 hours. After the mixture was allowed to cool, the mixture was concentrated. The residue, with water remaining, was extracted with toluene, and the organic layer was sequentially washed with water and saturated saline solution and was then dried with anhydrous magnesium sulfate. The desiccant was removed by filtration, and the filtrate was stirred and heated, and then 20 g of silica gel was added at 80°C and was stirred for 1 hour. The solid was then removed by hot filtration, and the filtrate was concentrated. The residue was recrystallized with a toluene solvent, to obtain 26.0 g of a yellowish-white powder of N-([1,1'-biphenyl]-4-yl)-5'-(naphthalen-2-yl)-[1,1' :2', 1" -terphenyl]-4-amine (yield: 78.0%).

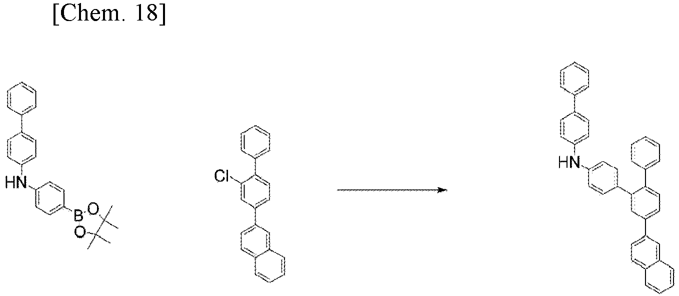

A reaction vessel was charged with 24.6 g of N-([1,1'-biphenyl]-4-yl)-5'-(naphthalen-2-yl)-[1,1':2',1"-terphenyl]-4-amine, 14.7 g of 2-(4-bromophenyl)naphthalene, 250 mL of toluene, and 6.8 g of sodium t-butoxide, then 0.4 g of tris(dibenzylideneacetone)dipalladium and 0.4 g of a 50% toluene solution of tri(t-butyl)phosphine were added thereto, and the mixture was stirred under reflux for 4 hours. The mixture was cooled to 80°C, and then hot filtration was performed using a celite-padded funnel to remove the solid. The filtrate was heated and stirred, and then 17 g of silica gel and 17 g of activated clay were added at 80°C and stirred for 1 hour. The solid was removed by filtration, and the filtrate was concentrated. The residue was purified by crystallization with a toluene/acetone mixed solvent, to obtain 21.0 g of a yellowish-white powder of N-([1,1'-biphenyl]-4-yl)-5'-(naphthalen-2-yl)-N-(4-(naphthalen-2-yl)phenyl)-[1,1':2',1"-terphenyl]-4-amine (1-102) (yield: 61.5%).

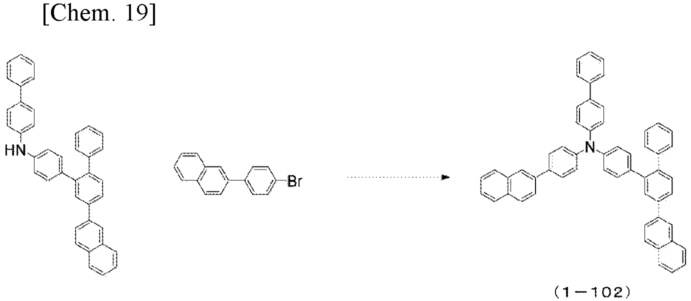

The structure of the obtained yellowish-white powder was identified by detecting the following 39 hydrogen signals by ¹H-NMR (CDCl₃).

δ (ppm) = 8.14 (1H), 8.01 (1H), 7.82-7.93 (8H), 7.71-7.77 (2H), 7.39-7.63 (13H), 7.05-7.32 (14H).

### Synthesis Example 9:

### Synthesis of N-([1,1'-biphenyl]-4-yl)-5'-phenyl-N-(4-(3-phenylnaphthalen-1-yl)phenyl)-[1,1':2',1"-te rphenyl]-4-amine (1-103):

A reaction vessel was charged with 32.7 g of 2'-bromo-[1,1':4',1"-terphenyl], 24.8 g of N-(4-(4,4,5,5-tetramethyl-1,3,2-dioxaborolane-2-yl)phenyl)-[1,1'-biphenyl]-4-amine, 320 mL of toluene, 90 mL of ethanol, 21.9 g of potassium carbonate, and 80 mL of water, then 1.2 g of tetrakis(triphenylphosphine)palladium was added thereto, and the mixture was stirred under reflux for 13 hours. The mixture was allowed to cool, and the precipitated solid was collected by filtration. Then, 250 mL of methanol and 250 mL of water were added thereto, dispersion washing was performed for 1 hour under reflux, and then the solid was collected by filtration. To the solid, 750 mL of toluene was added and stirred, and this was once heated to 100°C to confirm that methanol and water were removed, and then the mixture was cooled to 80°C. Then, 10 g of silica gel was added and stirred for 1 hour, and the solid was removed by hot filtration. The filtrate was concentrated, and the residue was crystallized by an acetone solvent, to obtain 33.0 g of a yellowish-white powder of N-([1,1'-biphenyl]-4-yl)-5'-phenyl-[1,1':2',1"-terphenyl]-4-amine (yield: 65.9%).

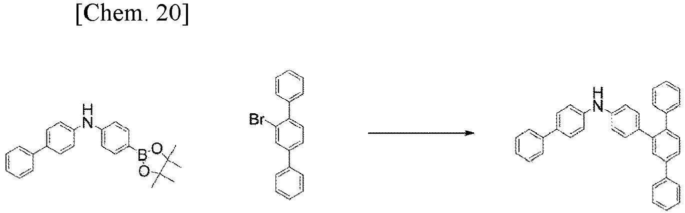

A reaction vessel was charged with 10.2 g of N-([1,1'-biphenyl]-4-yl)-5'-phenyl-[1,1':2',1"-terphenyl]-4-amine, 7.0 g of 1-(4-bromophenyl)-3-phenylnaphthalene, 70 mL of toluene, and 2.8 g of sodium t-butoxide, then 0.1 g of palladium acetate and 0.4 g of a 50% toluene solution of tri(t-butyl)phosphine were added thereto, and the mixture was stirred under reflux for 4 hours. The mixture was cooled to room temperature, then methanol was added thereto, and the precipitated solid was collected by filtration. To the solid, 300 mL of toluene was added, stirred, and heated, and then 7 g of silica gel and 7 g of activated clay were added at 80°C and stirred for 1 hour. The solid was removed by hot filtration, and the filtrate was concentrated. The residue was recrystallized with a dichloromethane/acetone mixed solvent, to obtain 10.9 g of a white powder of N-([1,1'-biphenyl]-4-yl)-5'-phenyl-N-(4-(3-phenylnaphthalen-1-yl)phenyl)-[1,1':2',1"-te rphenyl]-4-amine (1-103) (yield: 74.2%).

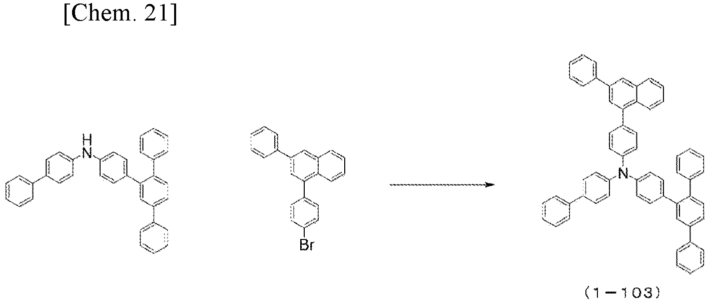

The structure of the obtained white powder was identified by detecting the following 41 hydrogen signals by ¹H-NMR (CDCl₃).

δ (ppm) = 8.01-8.03 (2H), 7.94-7.96 (1H), 7.58-7.77 (9H), 7.22-7.53 (25H), 7.08-7.15 (4H).

The glass transition point was measured for each of the triarylamine compounds represented by general formula (1) as obtained in Synthesis Examples 1 to 9 by using a high-sensitivity differential scanning calorimeter (DSC3100SA from Bruker AXS). The results are shown below.
Compound of Synthesis Example 1: 107.1°C
Compound of Synthesis Example 2: 131.2°C
Compound of Synthesis Example 3: 129.7°C
Compound of Synthesis Example 4: 110.0°C
Compound of Synthesis Example 5: 127.9°C
Compound of Synthesis Example 6: 109.5°C
Compound of Synthesis Example 7: 136.2°C
Compound of Synthesis Example 8: 109.1°C
Compound of Synthesis Example 9: 118.7°C

These measurement results show that the triarylamine compounds represented by general formula (1) to be used in the present invention have a glass transition point of 100°C or higher, and this shows that the thin-film state is stable.

A 100-nm-thick vapor deposition film was formed on an ITO substrate by using the respective triarylamine compounds represented by general formula (1) as obtained in Synthesis Examples 1 to 9, and the HOMO level (ionization potential) was measured using an ionization potential measurement device (PYS-202 from Sumitomo Heavy Industries, Ltd.). The results are shown below.
Compound of Synthesis Example 1: 5.67 eV
Compound of Synthesis Example 2: 5.72 eV
Compound of Synthesis Example 3: 5.75 eV
Compound of Synthesis Example 4: 5.72 eV
Compound of Synthesis Example 5: 5.76 eV
Compound of Synthesis Example 6: 5.69 eV
Compound of Synthesis Example 7: 5.68 eV
Compound of Synthesis Example 8: 5.67 eV
Compound of Synthesis Example 9: 5.73 eV

These measurement results show that the triarylamine compounds represented by general formula (1) as obtained in Synthesis Examples 1 to 9 have a suitable energy level and have good hole transportability, compared to the HOMO level of 5.4 eV of typical hole-transporting materials such as NPD, TPD, etc.

### Example 1:

An organic EL device was prepared using Compound (1-4) obtained in Synthesis Example 1.

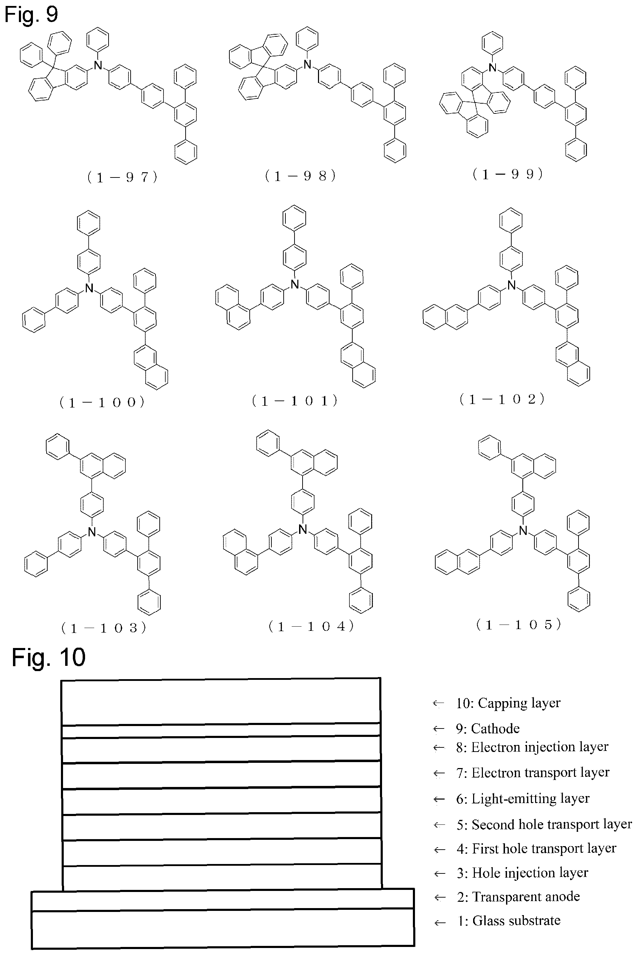

The organic EL device was prepared as illustrated in Fig. 10 by vapor-depositing a hole injection layer 3, a first hole transport layer 4, a second hole transport layer 5, a light-emitting layer 6, an electron transport layer 7, an electron injection layer 8, a cathode 9, and a capping layer 10 in this order onto a glass substrate 1 having formed thereon a reflective ITO electrode as a transparent anode 2 in advance.

More specifically, a glass substrate 1 having formed thereon, in order, a 50-nm-thick ITO film, a 100-nm-thick silver-alloy reflective film, and a 5-nm-thick ITO film was subjected to ultrasonic cleaning in isopropyl alcohol for 20 minutes, and then dried for 10 minutes on a hot plate heated to 250°C. Then, after UV ozone treatment for 15 minutes, the glass substrate having the ITO was mounted to a vacuum vapor deposition apparatus, in which the pressure was reduced to 0.001 Pa or lower. Next, a hole injection layer 3 was formed so as to cover the transparent anode 2 and so that the film thickness was 10 nm, by performing binary vapor deposition of an electron acceptor (Acceptor-1) having the following structural formula and Compound (1-4) obtained in Synthesis Example 1 at a rate at which the vapor deposition rate ratio between Acceptor-1 and Compound (1-4) was 3:97.

On this hole injection layer 3, Compound (1-4) of Example 1 was formed as a first hole transport layer 4 having a film thickness of 140 nm.

On this hole transport layer 4, the following Compound (HTM-1) was formed as a second hole transport layer 5 having a film thickness of 5 nm.

On this second hole transport layer 5, a light-emitting layer 6 was formed so that the film thickness was 20 nm, by performing binary vapor deposition of the following Compound (EMD-1) and Compound (EMH-1) having the following structural formula at a rate at which the vapor deposition rate ratio between Compound (EMD-1) and Compound (EMH-1) was 5:95.

On this light-emitting layer 6, an electron transport layer 7 was formed so that the film thickness was 30 nm, by performing binary vapor deposition of Compound (ETM-1) having the following structural formula and Compound (ETM-2) having the following structural formula at a rate at which the vapor deposition rate ratio between Compound (ETM-1) and Compound (ETM-2) was 50:50.

On this electron transport layer 7, lithium fluoride was formed as an electron injection layer 8 having a film thickness of 1 nm.

On this electron injection layer 8, a magnesium-silver alloy was formed as a cathode 9 having a film thickness of 12 nm.

Finally, Compound (CPL-1) having the following structure was formed as a capping layer 10 having a film thickness of 60 nm.

Light emission properties of the produced organic EL device were measured by applying a direct-current voltage thereto in the atmosphere at atmospheric temperature. The results are collectively shown in Table 1.

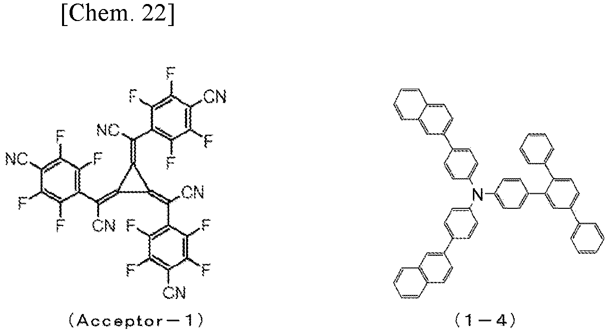

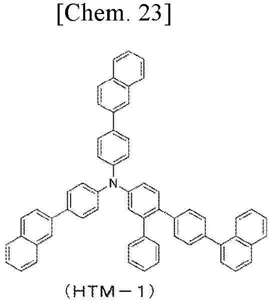

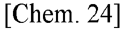

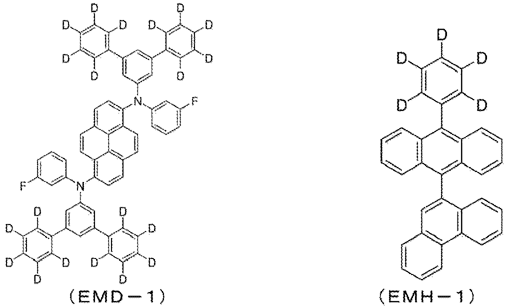

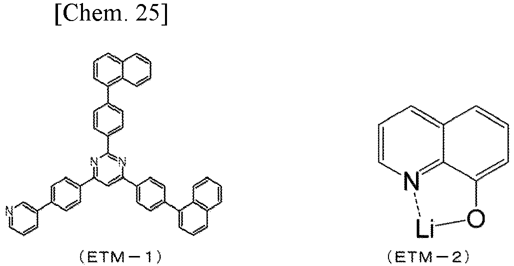

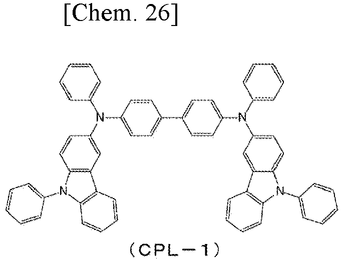

### Example 2:

An organic EL device was produced according to the same conditions, except that, in Example 1, Compound (1-58) of Synthesis Example 2 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 3:

An organic EL device was produced according to the same conditions, except that, in Example 1, Compound (1-59) of Synthesis Example 3 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 4:

An organic EL device was produced according to the same conditions, except that, in Example 1, Compound (1-69) of Synthesis Example 4 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 5:

An organic EL device was produced according to the same conditions, except that, in Example 2, Compound (1-83) of Synthesis Example 5 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 6:

An organic EL device was produced according to the same conditions, except that, in Example 1, Compound (1-96) of Synthesis Example 6 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 7:

An organic EL device was produced according to the same conditions, except that, in Example 1, Compound (1-97) of Synthesis Example 7 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 8:

An organic EL device was produced according to the same conditions, except that, in Example 1, Compound (1-102) of Synthesis Example 8 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Example 9:

An organic EL device was produced according to the same conditions, except that, in Example 1, Compound (1-103) of Synthesis Example 9 was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

### Comparative Example 1:

For comparison, an organic EL device was produced according to the same conditions, except that, in Example 1, Compound (HTM-2) having the following structural formula was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

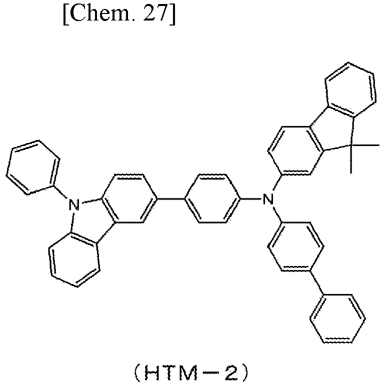

### Comparative Example 2:

For comparison, an organic EL device was produced according to the same conditions, except that, in Example 1, Compound (HTM-3) having the following structural formula was used instead of Compound (1-4) of Synthesis Example 1 as the material for the first hole transport layer 4. For the produced organic EL device, light emission properties were measured by applying a direct-current voltage thereto in the atmosphere at atmospheric temperature. The results are collectively shown in Table 1.

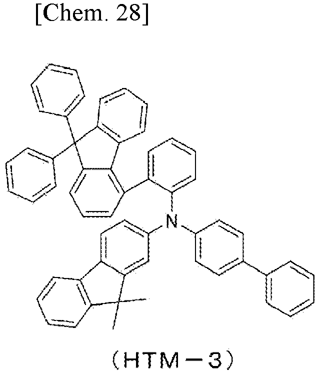

The voltage, luminance, luminous efficiency, and power efficiency of the Examples and Comparative Examples collectively shown in Table 1 are values for when a current with a current density of 10 mA/cm² was passed therethrough. The device life was found by performing constant current driving, with the light emission luminance at the start of light emission (i.e., initial luminance) set to 2000 cd/m², and measuring the time it took for the light emission luminance to attenuate to 1900 cd/m² (95% attenuation: amounting to 95% when the initial luminance is considered 100%).

**[Table 1]**

| | First hole transport layer | Voltage [V] | Luminance [cd/m²] | Luminous efficiency [cd/A] | Power efficiency [lm/W] | Device life [h] |
|---|---|---|---|---|---|---|
| Example 1 | Compound (1-4) | 3.50 | 1055 | 10.55 | 9.47 | 416 |
| Example 2 | Compound (1-58) | 3.49 | 1033 | 10.33 | 9.30 | 398 |
| Example 3 | Compound (1-59) | 3.49 | 1031 | 10.31 | 9.29 | 422 |
| Example 4 | Compound (1-69) | 3.48 | 1070 | 10.71 | 9.68 | 407 |
| Example 5 | Compound (1-83) | 3.46 | 1026 | 10.27 | 9.32 | 434 |
| Example 6 | Compound (1-96) | 3.52 | 1046 | 10.46 | 9.34 | 418 |
| Example 7 | Compound (1-97) | 3.50 | 1077 | 10.78 | 9.68 | 383 |
| Example 8 | Compound (1-102) | 3.44 | 1016 | 10.16 | 9.27 | 488 |
| Example 9 | Compound (1-103) | 3.43 | 999 | 9.99 | 9.17 | 536 |
| Comparative Example 1 | Compound (HTM-2) | 3.58 | 897 | 8.97 | 7.88 | 328 |
| Comparative Example 2 | Compound (HTM-3) | 3.54 | 876 | 8.77 | 7.79 | 353 |

As shown in Table 1, while the voltage when a current having a current density of 10 mA/cm² was passed was 3.54 to 3.58 V for Comparative Examples 1 and 2, Examples 1 to 9 clearly had lower voltages of 3.43 to 3.52 V Further, while the luminous efficiency when a current having a current density of 10 mA/cm² was passed was 8.77 to 8.97 cd/A for Comparative Examples 1 and 2, Examples 1 to 9 clearly had higher efficiency of 9.99 to 10.78 cd/A. Furthermore, while Comparative Examples 1 and 2 had a power efficiency of 7.79 to 7.88 lm/W, Examples 1 to 9 clearly had higher efficiency of 9.17 to 9.68 lm/W. Moreover, while Comparative Examples 1 and 2 had a device life (95% attenuation) of 328 to 353 hours, Examples 1 to 9 were capable of considerably prolonging lifetime to 383 to 536 hours.

The above results clearly show that the triarylamine compounds having a specific structure represented by general formula (1), used as a material for the hole transport layer, and more preferably for the first hole transport layer, in the present invention had higher hole mobility compared to conventional triarylamine compounds used in the Comparative Examples. Hence, as shown in Examples 1 to 9, the organic EL devices of the present invention were organic EL devices having lower driving voltage, higher luminous efficiency, and longer lifetime, compared to the organic EL devices of the Comparative Examples.

### Industrial Applicability

The organic EL device according to the present invention, which uses a triarylamine compound having a specific structure, has improved luminous efficiency compared to conventional organic EL devices, and also, the organic EL device can be improved in durability. Thus, for example, application can be expanded to home electrical appliances and lightings.

### Reference Signs List

1: Glass substrate
2: Transparent anode
3: Hole injection layer
4: First hole transport layer
5: Second hole transport layer
6: Light-emitting layer
7: Electron transport layer
8: Electron injection layer
9: Cathode
10: Capping layer

## Claims

1. An organic electroluminescence device comprising, between an anode and a cathode, at least
a hole transport layer,
a light-emitting layer, and
an electron transport layer
in this order from the anode side, wherein
the hole transport layer contains a triarylamine compound represented by general formula (1) below: 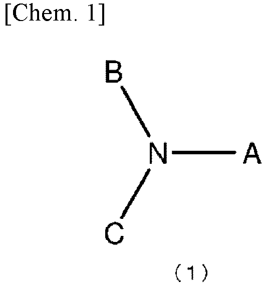
(in the formula, A represents a monovalent group represented by general formula (2-1) below;
B represents a substituted or unsubstituted aromatic hydrocarbon group, a substituted or unsubstituted aromatic heterocyclic group, or a substituted or unsubstituted fused aromatic group; and
C represents a monovalent group represented by general formula (2-1) below, a substituted or unsubstituted aromatic hydrocarbon group, a substituted or unsubstituted aromatic heterocyclic group, or a substituted or unsubstituted fused aromatic group); 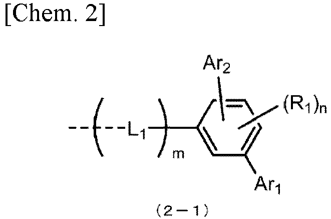
(in the formula, the broken line represents a bonding site;
Ri represents a deuterium atom, a fluorine atom, a chlorine atom, a cyano group, a nitro group, a linear or branched alkyl group having 1 to 6 carbon atoms and optionally having a substituent, a cycloalkyl group having 5 to 10 carbon atoms and optionally having a substituent, a linear or branched alkenyl group having 2 to 6 carbon atoms and optionally having a substituent, a linear or branched alkyloxy group having 1 to 6 carbon atoms and optionally having a substituent, a cycloalkyloxy group having 5 to 10 carbon atoms and optionally having a substituent, a substituted or unsubstituted aromatic hydrocarbon group, a substituted or unsubstituted aromatic heterocyclic group, a substituted or unsubstituted fused polycyclic aromatic group, or a substituted or unsubstituted aryloxy group;
n is the number of R₁ and represents an integer from 0 to 3, wherein, when n is 2 or 3, the plurality of Ris bonded to the same benzene ring may be the same or different from one another and may be bonded to each other via a single bond, a substituted or unsubstituted methylene group, an oxygen atom, or a sulfur atom, to form a ring;
Li represents a divalent group of a substituted or unsubstituted aromatic hydrocarbon or of a substituted or unsubstituted aromatic heterocycle or of a substituted or unsubstituted fused polycyclic aromatic;
m is the number of L₁ and represents an integer from 1 to 3, wherein, when m is 2 or 3, Li may be the same or different from one another; and
An and Ar₂ may be the same or different from one another and each represent a substituted or unsubstituted aromatic hydrocarbon group, a substituted or unsubstituted aromatic heterocyclic group, or a substituted or unsubstituted fused polycyclic aromatic group).

2. The organic electroluminescence device according to claim 1, wherein the monovalent group represented by the general formula (2-1) is a monovalent group represented by general formula (2-2) below: 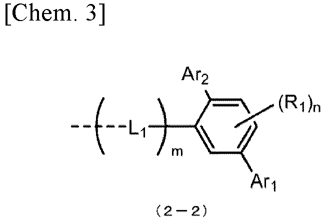 (in the formula, An, Ar₂, Li, m, n, and R₁ have same definitions as those in the general formula (2-1)).

3. The organic electroluminescence device according to claim 1, wherein the monovalent group represented by the general formula (2-1) is a monovalent group represented by general formula (2-3) below: 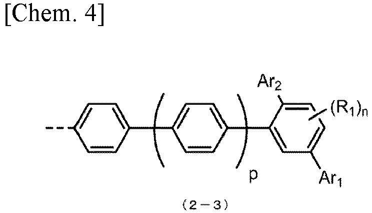
(in the formula, An, Ar₂, n, and R₁ have same definitions as those in the general formula (2-1); and
p represents 0 or 1).

4. The organic electroluminescence device according to claim 1, wherein the monovalent group represented by the general formula (2-1) is a monovalent group represented by general formula (2-4) below: 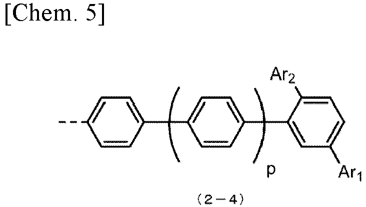
(in the formula, An and Ar₂ have same definitions as those in the general formula (2-1); and
p represents 0 or 1).

5. The organic electroluminescence device according to any one of claims 1 to 4, wherein:
the hole transport layer is constituted by two layers including a first hole transport layer and a second hole transport layer; and
the first hole transport layer contains the triarylamine compound represented by the general formula (1).
